Europäisches Patentamt

European Patent Office

Office européen des brevets

(19)

(11) Numéro de publication: **0 358 145 B1**

(12)

# FASCICULE DE BREVET EUROPEEN

(45) Date de publication de fascicule du brevet: **27.10.93**   (51) Int. Cl.⁵: **G01R 15/06**

(21) Numéro de dépôt: **89116284.4**

(22) Date de dépôt: **04.09.89**

(54) Dispositif de mesure des tensions d'une installation triphasée, notamment de type blindé.

(30) Priorité: **09.09.88 FR 8811793**

(43) Date de publication de la demande:
**14.03.90 Bulletin 90/11**

(45) Mention de la délivrance du brevet:
**27.10.93 Bulletin 93/43**

(84) Etats contractants désignés:
**AT BE CH DE ES FR GB GR IT LI LU NL SE**

(56) Documents cités:
**FR-A- 2 221 737**
**FR-A- 2 456 327**
**GB-A- 2 131 558**

(73) Titulaire: **GEC ALSTHOM SA**
**38, avenue Kléber**
**F-75116 Paris(FR)**

(72) Inventeur: **Dupraz, Jean-Pierre**
**7 rue Moissonier**
**F-69003 Lyon(FR)**
Inventeur: **Moncorge, Jean-Paul**
**30 Chemin de la Rize**
**F-69120 Vaux en Velin(FR)**

(74) Mandataire: **Weinmiller, Jürgen et al**
**Lennéstrasse 9**
**Postfach 24**
**D-82336 Feldafing (DE)**

## Description

La présente invention concerne un dispositif de mesure de tension, appliquable à une cellule blindée triphasée. Dans une telle cellule les équipements des trois phases sont dans une même enveloppe. Si on veut réaliser la mesure des tensions à l'aide de diviseurs capacitifs, la mesure de la tension d'une phase donnée est influencée par les capacités parasites dues aux autres phases.

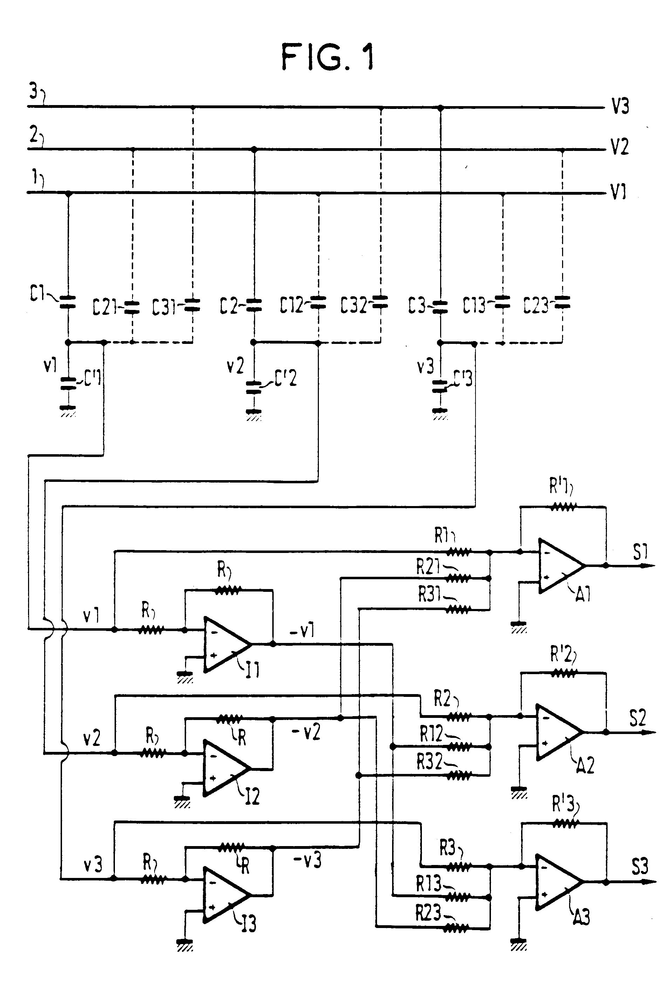

Cet état de chose est illustré dans la figure 1, où les références 1, 2 et 3 représentent les barres conductrices d'une installation blindée triphasée, de tensions respectives V1, V2, V3.

Les capacités C1, C'1 ; C2, C'2; C3, C'3 représentent les capacités de trois diviseurs capacitifs de type classique.

Les tensions v1, v2, v3 aux bornes de C'1, C'2 et C'3 respectivement constituent les images des tensions à mesurer.

Les tensions v1, v2 et v3 ne sont pas rigoureusement proportionnelles à V1, V2 et V3 en raison des capacités parasites C21, C31 pour la phase 1, C12, C32 pour la phase 2 et C13, C23 pour la phase 3.

Au contraire, les tensions mesurées v1, v2 et v3 sont de la forme

v1 = K1 V1 + K21 V2 + K31 V3
v2 = K21 V1 + K2 V2 + K32 V3
v3 = K31 V1 + K32 V2 + K3 V3

Dans le document FR-A-2 221 737, il est décrit un dispositif pour la mesure des tensions d'une installation triphasée comprenant, pour chaque conducteur, un diviseur capacitif comportant un condensateur haute tension et un condensateur de mesure.

La tension aux bornes de chacun des condensateurs de mesure est appliquée à l'entrée d'un préamplificateur dont la sortie est reliée à un amplificateur. La sortie de chacun des préamplificateurs est reliée par des résistances à l'entrée des deux autres amplificateurs.

En réglant les valeurs des résistances précitées, on peut obtenir, en sortie des amplificateurs, des tensions de mesure dont le module est indépendant des perturbations dues à la présence de capacités parasite. Mais ce montage ne permet pas de régler également la phase des tensions de mesure, le réglage du zéro d'une phase agissant sur le zéro des autres phases.

Un but de la présente invention est de réaliser un dispositif de mesure des tensions d'une installation triphasée au moyen de diviseurs capacitifs, dans lequel les réglages de correction de mutuelle inductance sont indépendants pour les trois phases.

La présente invention a ainsi pour objet un dispositif de mesure des tensions d'une installation triphasée notamment du type blindé, comprenant pour chacun des conducteurs de phase, un diviseur capacitif comprenant un premier condensateur connecté d'une part audit conducteur et d'autre part à un second condensateur connecté à la masse la tension de chacun des seconds condensateurs des diviseurs etant respectivement appliquée d'une part à l'entrée d'un inverseur et d'autre part, par l'intermédiaire d'une première résistance à l'entrée négative d'un amplificateur opérationnel reliée également, à travers des secondes et troisièmes résistances respectivement aux sorties des inverseurs des deux autres phase, les secondes et troisiemes resistances etant choisies pour que, lorsqu'une phase seulement est sous tension les tensions de sortie des amplificateurs opérationnels correspondant aux autres phases soient nulles, les tensions de sortie des amplificateurs étant, après ledit réglage, respectivement proportionnelles aux tensions des conducteurs.

L'invention a également pour objet un dispositif de mesure des tensions d'une installation triphasée notamment de type blindé, comprenant pour chaque conducteur de phase un premier condensateur connecté d'une part audit conducteur et d'autre part à un amplificateur opérationnel monté en intégrateur avec un second condensateur, la tension de sortie desdits amplificateurs montés en intégrateur étant respectivement appliquée d'une part à l'entrée d'un inverseur et d'autre part, par l'intermédiaire d'une première résistance à l'entrée négative d'un autre amplificateur opérationnel reliée également, à travers des secondes et troisièmes résistances, respectivement aux sorties des inverseurs des deux autres phases, les secondes et troisièmes résistances étant choisies pour que, lorsqu'une phase seulement est sous tension, les tensions de sortie desdits autres amplificateurs opérationnels correspondant aux autres phases soient nulles, les tensions de sortie desdits autres amplificateurs étant, après ledit réglage, respectivement proportionnelles aux tensions des conducteurs.

Avantageusement, les inverseurs sont des amplificateurs opérationnels montés en inverseurs.

L'invention sera bien comprise par la description ci-apres donnée en référence au dessin annexé dans lequel :

- la figure 1 est un schéma du dispositif de l'invention selon un premier mode de réalisation de l'invention,
- la figure 2 est un schéma partiel d'une variante.

A la partie supérieure de la figure 1, on reconnait le schéma classique d'un dispositif de mesure à diviseurs capacitifs.

Chacune des tensions v1, v2, v3 est reliée à l'entrée négative d'un amplificateur opérationnel (I1, I2, I3) monté en inverseur grâce à une résistance d'entrée de valeur R et une résistance en parallèle de même valeur.

La tension v1 est égelement appliqué par une résistance de valeur R1 à l'entrée négative d'un amplificateur opérationnel A1 muni d'une résistance de valeur R'1 en parallèle.

En outre, l'entrée négative de l'amplificateur A1 est reliée à la sortie des inverseurs I2 et I3 par l'intermédiaire de résistances de valeur R21 et R31 respectivement.

On désigne par S1 le signal de sortie de l'amplificateur A1.

De manière analogue, la tension de v2 est appliquée par une résistance de valeur R2 à l'entrée négative d'un amplificateur opérationnel A2 muni d'une résistance de valeur R'2 en parallèle.

L'entrée négative de l'amplificateur A2 est reliée à la sortie des inverseurs I1 et I3 par l'intermédiaire de résistances de valeur R12 et R32 respectivement. On désigne par S2 le signal de sortie de l'amplificateur A2.

Enfin, la tension v3 est appliquée par une résistance de valeur R3 à l'entrée négative d'un amplificateur opérationnel A3 muni d'une résistance R'3 en parallèle. L'entrée négative de l'amplificateur A3 est reliée à la sortie des inverseurs I1 et I2 par l'intermédiaire de résistances R13 et R23 respectivement. On désigne par S3 le signal de sortie de l'amplicateur A3.

On ajuste les résistances par exemple de la manière suivante :

- On met la barre 1 sous tension, les barres 2 et 3 étant à tension nulle. On ajuste R12 pour que le signal S2 soit nul. On ajuste R13 pour que le signal S3 soit nul.
- On recommence l'opération avec la barre 2 seule sous tension ce qui permet d'ajuster R21 et R23, puis avec la barre 3 seule sous tension pour ajuster R31 et R32.

Après ce réglage on a les relations ci-après :

$$S1 = k1 \ V1$$
$$S2 = k2 \ V2$$
$$S3 = k3 \ V3$$

où k1, k2 et k3 sont des constantes.

On a donc bien ainsi éliminé l'influence les capacités parasites.

Le fait d'utiliser des amplificateurs inverseurs I1, I2, I3 permet d'utiliser le type de montage décrit plus haut et de résoudre le problème posé.

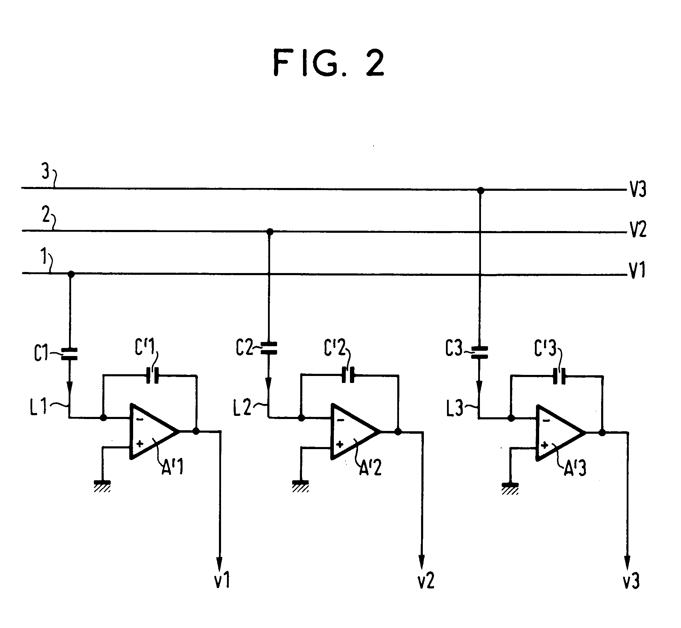

La figure 2 représente une variante du montage dans lequel le diviseur capacitif classique est constitué, pour chaque phase respectivement par un premier condensateur C1, C2, C3 en série avec un amplificateur opérationnel A'1, A'2, A'3 monté en intégrateur c'est-à-dire ayant entre sa borne d'entrée négative et sa sortie une second condensateur C'1, C'2, C'3. Le reste du montage est inchangé.

On a :

$$v1 = - \frac{C'1}{C1} \ V1$$

$$v2 = - \frac{C'2}{C2} \ V2$$

$$v3 = - \frac{C'3}{C3} \ V3$$

La simple adjonction des amplificateurs intégrateurs A'1, A'2, A'3 permet la mesure de tension par amplification des courants il, i2, i3 traversant C1, C2, C3.

## Revendications

1. Dispositif de mesure des tensions d'une installation triphasée notamment du type blindé, comprenant pour chacun des conducteurs de phase (1,2,3), un diviseur capacitif comprenant un premier condensateur (C1,C2,C3) connecté d'une part audit conducteur (1,2,3) et d'autre part à un second condensateur (C'1, C'2, C'3) connecte a la masses, la tension (v1, v2, v3) de chacun des seconds condensateurs (C'1, C'2, C'3) des diviseurs étant respectivement appliquée d'une part à l'entrée d'un inverseur (I1, I2, I3) et d'autre part, par l'intermédiaire d'une première résistance (R1, R2, R3) à l'entrée négative d'un amplificateur opérationnel (A1, A2, A3) reliée également, à travers des secondes (R21, R12, R13) et troisièmes (R31, R32, R23) résistances respectivement aux sorties des inverseurs (I1, I2, I3) des deux autres phases, les secondes et troisièmes résistances (R21, R12, R13; R31, R32, R23) étant choisies pour que, lorsqu'une phase seulement est sous tension les tensions de sortie des amplificateurs opérationnels (A1, A2, A3) correspondant aux autres phases soient nulles, les tensions de sortie des amplificateurs (A1, A2, A3) étant, après ledit réglage, respectivement proportionnelles aux tensions des conducteurs (1,2,3).

2. Dispositif de mesure des tensions d'une installation triphasée notamment du type blindé, comprenant pour chaque conducteur de phase (1,2,3) un premier condensateur (C1, C2, C3) connecté d'une part audit conducteur (1,2,3,)

et d'autre part à un amplificateur opérationnel (A'1, A'2, A'3) monté en intégrateur avec un second condensateur (C'1, C'2, C'3), la tension de sortie (v1, v2, v3) desdits amplificateurs montés en intégrateur (A'1, A'2, A'3) étant respectivement appliquée d'une part à l'entrée d'un inverseur (I1, 12, I3) et d'autre part, par l'intermédiaire d'une première résistance (R1, R2, R3) à l'entrée négative d'un autre amplificateur opérationnel (A1, A2, A3) reliée également, à travers des secondes (R21, R12, R13) et troisièmes (R31, R32, R23) résistances respectivement aux sorties des inverseurs (I1, I2, I3) des deux autres phases, les, secondes et troisièmes résistance (R21, R12, R13; R31, R32, R23) étant choisies pour que, lorsqu'une phase seulement est sous tension les tensions de sortie desdits autres amplificateurs opérationnels (A1,A2,A3) correspondant aux autres phases soient nulles, les tensions de sortie desdits autres amplificateurs (A1, A2, A3) étant, après ledit réglage, respectivement proportionnelles aux tensions des conducteurs (1,2,3).

3. Dispositif selon l'une des revendications 1 et 2, caractérisé en ce que les inverseurs (I1, I2, I3) sont des amplificateurs opérationnels montés en inverseur.

## Claims

1. A circuit for measuring voltages in a three-phase installation, in particular an installation of the metalclad type, the circuit comprising, for each of the phase conductors (1, 2, 3), a capacitive divider comprising a first capacitor (C1, C2, C3) connected firstly to said conductor (1, 2, 3) and secondly to a second capacitor (C'1, C'2, C'3) connected to ground, the voltage (v1, v2, v3) of each of the second capacitors (C'1, C'2, C'3) of the dividers being respectively applied firstly to the input of an inverter (I1, I2, I3) and secondly via a first resistance (R1, R2, R3) to the negative input of an operational amplifier (A1, A2, A3) which is also connected via second and third resistances (R21, R12, R13, and R31, R32, R23) respectively to the outputs of the inverters (I1, I2, I3) on the other two phases, with the second and third resistances (R21, R12, R13; R31, R32, R23) being selected in such a manner that when only one of the phases is under tension, then the output voltages from the operational amplifiers (A1, A2, A3) corresponding to the other phases become zero, with the output voltages from the amplifiers (A1, A2, A3) being, after said adjustment, respectively proportional to the voltages of the conductors (1, 2, 3).

2. A circuit for measuring voltages in a three-phase installation, in particular an installation of the metalclad type, the circuit comprising, for each phase conductor (1, 2, 3), a first capacitor (C1, C2, C3) connected firstly to said conductor (1, 2, 3) and secondly connected to an operational amplifier (A'1, A'2, A'3) mounted as an integrator with a second capacitor (C'1, C'2, C'3), the output voltage (v1, v2, v3) from each of said amplifiers mounted as an integrator (A'1, A'2, A'3) being respectively applied firstly to the input of an inverter (I1, I2, I3) and secondly via a first resistance (R1, R2, R3) to the negative input of another operational amplifier (A1, A2, A3) which is also connected via second and third resistances (R21, R12, R13, and R31, R32, R23) respectively to the outputs of the inverters (I1, I2, I3) on the other two phases, with the second and third resistances (R21, R12, R13; R31, R32, R23) being selected in such a manner that when only one of the phases is under tension, then the output voltages from said other operational amplifiers (A1, A2, A3) corresponding to the other phases become zero, with the output voltages from said other amplifiers (A1, A2, A3) being, after said adjustment, respectively proportional to the voltages of the conductors (1, 2, 3).

3. A circuit according to claim 1 or 2, characterized in that the inverters (I1, I2, I3) are operational amplifiers connected as inverters.

## Patentansprüche

1. Vorrichtung zur Messung der Spannungen einer Dreiphasenanlage, insbesondere vom abgeschirmten Typ, die für jeden der Phasenleiter (1, 2, 3) einen kapazitiven Teiler mit einem ersten Kondensator (C1, C2, C3) enthält, der einerseits an den Leiter (1, 2, 3) und andererseits an einen zweiten mit Masse verbundenen Kondensator (C'1, C'2, C'3) angeschlossen ist, wobei die Spannung (v1, v2, v3) jedes der zweiten Kondensatoren (C'1, C'2, C'3) der Teiler einerseits an den Eingang eines Inverters (I1, I2, I3) und andererseits über einen ersten Widerstand (R1, R2, R3) an den negativen Eingang eines Operationsverstärkers (A1, A2, A3) angelegt ist, der auch über zweite (R21, R12, R13) und dritte Widerstände (R31, R32, R23) an die Ausgänge der Inverter (I1, I2, I3) der jeweils beiden anderen Phasen angeschlossen ist, wobei die zweiten und dritten Widerstände (R21, R12, R13; R31, R32, R23) so gewählt werden, daß, wenn nur eine Phase unter Spannung ist, die Ausgangsspannungen der Operationsverstärker (A1, A2, A3) entsprechend den anderen Phasen Null werden, so daß die Ausgangsspannungen der Verstärker (A1, A2, A3) nach dieser Regelung proportional zu den Spannungen der Leiter (1, 2, 3) werden.

2. Vorrichtung zur Messung der Spannungen einer Dreiphasenanlage, insbesondere vom abgeschirmten Typ, die für jeden der Phasenleiter (1, 2, 3) einen ersten Kondensator (C1, C2, C3) enthält, der einerseits an den Leiter (1, 2, 3) und andererseits an einen mit einem zweiten Kondensator (C'1, C'2, C'3) als Integrator geschalteten Operationsverstärker (A'1, A'2, A'3) angeschlossen ist, wobei die Ausgangsspannung (v1, v2, v3) der als Integrator beschalteten Verstärker (A'1, A'2, A'3) einerseits an den Eingang eines Inverters (I1, I2, I3) und andererseits über einen ersten Widerstand (R1, R2, R3) an den negativen Eingang eines anderen Operationsverstärkers (A1, A2, A3) angeschlossen ist, der außerdem über zweite (R21, R12, R13) bzw. dritte Widerstände (R31, R32, R23) mit den Ausgängen der Inverter (I1, I2, I3) der beiden anderen Phasen verbunden ist, wobei die Werte der zweiten und dritten Widerstände (R21, R12, R13; R31, R32, R23) so gewählt werden, daß, wenn nur eine Phase unter Spannung ist, die Ausgangsspannungen der anderen Operationsverstärker (A1, A2, A3) entsprechend den beiden anderen Phasen Null werden, so daß die Ausgangsspannungen dieser anderen Verstärker (A1, A2, A3) nach dieser Regelung proportional zu den Spannungen der Leiter (1, 2, 3) werden.

3. Vorrichtung nach einem der Ansprüche 1 und 2, dadurch gekennzeichnet, daß die Inverter (I1, I2, I3) als Inverter geschaltete Operationsverstärker sind.

# FIG. 1

# FIG. 2